# EUROPÄISCHE PATENTSCHRIFT

(11) **EP 3 766 107 B1**
(45) Veröffentlichungstag und Bekanntmachung des Hinweises auf die Patenterteilung: **10.07.2024**
(21) Anmeldenummer: 19711068.7
(22) Anmeldetag: 12.03.2019
(51) Int. Cl.: H10N 30/80

(54) **VORRICHTUNG ZUR ERZEUGUNG EINES NICHT-THERMISCHEN ATMOSPHÄRENDRUCK-PLASMAS UND VERFAHREN ZUM BETRIEB EINES PIEZOELEKTRISCHEN TRANSFORMATORS**
DEVICE FOR PRODUCING A NON-THERMAL ATMOSPHERIC PRESSURE PLASMA AND METHOD FOR OPERATING A PIEZOELECTRIC TRANSFORMER
DISPOSITIF DE GÉNÉRATION D'UN PLASMA NON THERMIQUE À PRESSION ATMOSPHÉRIQUE ET PROCÉDÉ POUR FAIRE FONCTIONNER UN TRANSFORMATEUR PIÉZOÉLECTRIQUE

(30) Priorität: 14.03.2018 DE 102018105895
(43) Veröffentlichungstag der Anmeldung: 20.01.2021
(73) Patentinhaber: TDK Electronics AG, 81671 München (DE)
(72) Erfinder: MISKOVIC, Goran, 8530 Deutschlandsberg (AT)
(74) Vertreter: Epping - Hermann - Fischer
(86) Internationale Anmeldenummer: PCT/EP2019/056169
(87) Internationale Veröffentlichungsnummer: WO 2019/175178

(56) Entgegenhaltungen:
- WO-A1-2017/081272
- DE-A1- 102008 057 423
- DE-A1- 102015 113 656
- DE-A1- 102017 105 415
- DE-B3- 102016 104 490
- US-A1- 2017 232 122

## Beschreibung

Die Erfindung betrifft eine Vorrichtung zur Erzeugung eines nicht-thermischen Atmosphärendruck-Plasmas sowie ein Verfahren zum Betrieb eines piezoelektrischen Transformators.

Piezoelektrische Transformatoren, insbesondere Transformatoren vom Rosen-Typ, können zur Erzeugung von Plasma eingesetzt werden. Bei der Plasmagenerierung wird eine hohe Effizienz erreicht, wenn der piezoelektrische Transformator mit einer Frequenz angesteuert wird, die der Serienresonanzfrequenz oder der Parallelresonanzfrequenz des Transformators entspricht. Die Serienresonanzfrequenz und die Parallelresonanzfrequenz sind jedoch nicht konstant, sondern hängen von verschiedenen Parametern ab. Wird an einer ausgangsseitigen Stirnseite des Transformators ein Plasma gezündet, so wirkt dieses als Last mit dem Transformator zusammen und beeinflusst dabei die Impedanz des Transformators. Dadurch kommt es zu einer Verschiebung der Serienresonanz und der Parallelresonanz gegenüber einem Betrieb des Transformators im Leerlauf, bei dem die angelegte Spannung zur Zündung eines Plasmas nicht ausreicht. Auch die Arbeitsumgebungen, beispielsweise das verwendete Prozessgas, die Temperatur des Transformators oder das Vorhandensein zusätzlicher oder wechselnder externer Lasten, beeinflussen die Serienresonanzfrequenz und die Parallelresonanzfrequenz. Ferner kann auch das an dem Transformator angelegte Eingangssignal die Serienresonanzfrequenz und die Parallelresonanzfrequenz beeinflussen.

Ein Beispiel findet sich in Patentschrift DE102015113656.Das Dokument betrifft einen Plasmagenerator, der einen piezoelektrischer Transformator, der zur Ionisation eines Prozessgases geeignet ist, eine Ionenseparationselektrode, und eine Ansteuerschaltung, die dazu geeignet ist, an die Ionenseparationselektrode ein Potential anzulegen, aufweist. Ferner betrifft die Erfindung ein Verfahren zur Einstellung des Verhältnisses von positiven zu negativen Ionen in einem von einem Plasmagenerator erzeugten Plasma.

Aufgabe der vorliegenden Erfindung ist es daher, eine verbesserte Vorrichtung zur Erzeugung eines nicht-thermischen Atmosphärendruck-Plasmas bereitzustellen. Eine weitere Aufgabe der Erfindung ist es ein verbessertes Verfahren zum Betrieb eines piezoelektrischen Transformators anzugeben.

Die Aufgaben werden durch die Gegenstände der unabhängigen Ansprüche gelöst.

Es wird eine Vorrichtung zur Erzeugung eines nicht-thermischen Atmosphärendruck-Plasmas vorgeschlagen, die einen piezoelektrischen Transformator, eine Ansteuerschaltung, die dazu ausgelegt ist, ein Eingangssignal an den piezoelektrischen Transformator anzulegen, und eine Feldsonde, die dazu ausgestaltet ist, eine Feldstärke eines von dem piezoelektrischen Transformator erzeugten elektrischen Feldes an einem Messpunkt, bevorzugt an zumindest zwei Messpunkten, zu messen, aufweist. Die Ansteuerschaltung ist dazu ausgestaltet, unter Berücksichtigung der Messergebnisse der Feldsonde das Eingangssignal anzupassen.

Durch die Messung der Feldstärke an zumindest zwei Messpunkten kann eine lokale Feldstärke an verschiedenen Positionen ermittelt werden. Die Vorrichtung kann es dementsprechend ermöglichen, einen räumlichen Verlauf des vom Transformator erzeugten elektrischen Feldes zu messen. Insbesondere kann es die Vorrichtung ermöglichen, den Ort zu bestimmen, an dem die Feldstärke ihr Maximum erreicht. Dieser Ort ist wesentlich für die Art der Plasmazündung. Liegt das Maximum der Feldstärke an einer ausgangsseitigen Stirnseite des Transformators oder vor dem Transformator, wird ein Plasma an der ausgangsseitigen Stirnseite gezündet. Liegt das Maximum der Feldstärke jedoch im Ausgangsbereich des Transformators und weist einen Abstand zur ausgangsseitigen Stirnseite des Transformators auf, kommt es zu Plasmazündungen entlang der Kanten des Ausgangsbereichs. Plasmazündungen an den Kanten können zu erheblichen mechanischen Belastungen des Transformators und zur Bildung von Rissen führen. Die Risse können den Transformator zerstören. Das an den Transformator angelegte Eingangssignal sollte daher nach Möglichkeit derart angepasst werden, dass sich das Maximum in der Feldstärke nicht im Ausgangsbereich des Transformators ausbildet.

Die Vorrichtung macht Gebrauch von den hohen elektrischen Feldstärken, die in der Umgebung des Ausgangsbereichs des piezoelektrischen Transformators erzeugt werden. Eine Vermessung dieser Feldstärke kann vorgenommen werden, ohne dabei die Arbeit des Transformators durch ein direktes, lastseitiges Abgreifen einer Leistung im Ausgangsbereich des Transformators zu beeinflussen. Insbesondere kann eine Vermessung der Feldstärke vorgenommen werden, ohne eine Schwingung des piezoelektrischen Transformators dadurch zu dämpfen.

Die Feldsonde kann in ein Gehäuse der Vorrichtung zur Erzeugung eines nicht-thermischen Atmosphärendruck-Plasmas integriert sein. Die Feldsonde kann in unmittelbarer Nähe zu dem piezoelektrischen Transformator angeordnet sein. Beispielsweise kann der Abstand zwischen dem piezoelektrischen Transformator und der Feldsonde kleiner als 5 cm cm sein. Vorzugsweise kann der Abstand zwischen dem piezoelektrischen Transformator und der Feldsonde kleiner als 3 cm sein, besonders bevorzugt kleiner als 1,5 cm oder sogar kleiner als 0,75 cm. Zwischen der Feldsonde und dem piezoelektrischen Transformator kann ein Spalt verbleiben. Der Spalt sollte breit genug sein, um eine Plasmazündung zwischen der Feldsonde und dem Transformator auszuschließen.

Je näher die Feldsonde an dem Transformator angeordnet ist, desto besser kann eine räumliche Auflösung der von der Feldsonde gemessenen Parameter sein. Allerdings darf der Abstand in Abhängigkeit von den vorliegenden Umgebungs- und Betriebsbedingungen nicht zu gering gewählt werden, um elektrische Kurzschlüsse und Überschläge zwischen der Feldsonde und dem Transformator auszuschließen. Bei Umgebungen mit einer vergleichsweise geringen Luftfeuchtigkeit reichen Abstände von 0,75 cm oder 1,5 cm aus, um Überschläge zuverlässig auszuschließen. Liegt jedoch eine vergleichsweise hohe Luftfeuchtigkeit vor, sollte eine Vorrichtung verwendet werden, die einen Abstand von 1,5 cm bis 3 cm zwischen der Feldsonde und dem Transformator aufweist. In ähnlicher Weise beeinflussen auch andere Parameter, wie beispielsweise das Prozessmedium bzw. die Zündfähigkeit des Prozessmediums, die Wahl des geeigneten Abstands.

Die Feldsonde ist dazu ausgestaltet die Feldstärke mit zumindest einem Messpunkt zu ermitteln. Vorzugsweise ist die Feldsonde dazu ausgestaltet die Feldstärke an mehr als zwei Messpunkten zu ermitteln. Besonders bevorzugt kann die Anzahl der Messpunkte zwischen 5 und 50 liegen, ganz besonders bevorzugt zwischen 8 und 30. Je höher die Anzahl der Messpunkte ist, desto besser kann eine Auflösung der Messung sein.

Die Ansteuerschaltung kann dazu ausgestaltet sein, unter Berücksichtigung der Messergebnisse der Feldsonde eine Frequenz des Eingangssignals anzupassen. Insbesondere kann die Frequenz des Eingangssignals auf die aktuelle Serienresonanzfrequenz oder die aktuelle Parallelresonanzfrequenz des Transformators eingestellt werden. Dabei können die aktuelle Serienresonanzfrequenz und/oder die aktuelle Parallelresonanzfrequenz aus den Messergebnissen der Feldsonde ermittelt werden. Die Ansteuerschaltung kann dazu ausgestaltet sein, unter Berücksichtigung der Messergebnisse der Feldsonde das Eingangssignal derart anzupassen, dass die Frequenz des Eingangssignals der einer Serienresonanzfrequenz des piezoelektrische Transformators entspricht oder dass die Frequenz des Eingangssignals der einer Parallelresonanzfrequenz des piezoelektrische Transformators entspricht. Dies ermöglicht eine Echtzeit Regelung des Ansteuersignals bzw. des Eingangssignals. Dies ermöglicht in weiterer Folge einen effizienteren Betrieb, weniger Verlust und geringere mechanische Belastungen des Transformators. Hiermit sinkt der Energiebedarf und es steigt die Lebensdauer des Bauteils.

Die Ansteuerschaltung kann jedoch auch dazu ausgestaltet sein, alternativ oder ergänzend zur Frequenz, weitere Parameter des Eingangssignals anzupassen, beispielsweise die Form, die Leistung, die Eingangsspannung, die Eingangsstromstärke und/oder die Phase.

Die Ansteuerschaltung kann dazu ausgestaltet sein, unter Berücksichtigung der Messergebnisse der Feldsonde das Eingangssignal derart anzupassen, dass ein Maximum in der Feldstärke des von dem piezoelektrischen Transformator erzeugten elektrischen Feldes sich an einer ausgangsseitigen Stirnseite des piezoelektrischen Transformators oder in einem vom piezoelektrischen Transformator wegweisenden Halbraum vor der ausgangsseitigen Stirnseite des piezoelektrischen Transformators ausbildet. Auf diese Weise können Plasmazündungen entlang der Kanten des Ausgangsbereichs vermieden werden, die andernfalls den Transformator beschädigen könnten.

Die Feldsonde kann ein Substrat aufweisend ein isolierendes Material aufweisen. Die Feldsonde kann voneinander getrennte Metallisierungen aufweisen, die die bevorzugt zumindest zwei Messpunkte bilden. Das Substrat kann eine Leiterplatte sein. Das Substrat kann einlagig oder mehrlagig sein. Die Metallisierungen können beispielsweise kreisförmig oder rechteckig sein. Ein von dem piezoelektrischen Transformator erzeugtes elektrisches Wechselfeld kann eine Wechselspannung in den Metallisierungen erzeugen. Die Wechselspannung kann zur Bestimmung der Feldstärke vermessen werden.

Die Feldsonde kann eine Metallfläche aufweisen, wobei die Vorrichtung dazu ausgestaltet ist, die Feldstärke an jedem Messpunkt durch eine Messung einer Spannung zwischen der Metallfläche und dem jeweiligen Messpunkt zu bestimmen. Auf diese Weise kann ein stabiles Messsignal erhalten werden. Lokale Unterschiede zwischen den einzelnen Messpunkten können dabei gut erkannt werden. Die Metallfläche kann einen Rahmen bilden. Die Metallfläche und die Metallisierungen können auf einer Unterseite des Substrats angeordnet sein, die vom piezoelektrischen Transformator wegweist, um Plasmazündungen gegen die Metallfläche oder die Metallisierungen zu vermeiden. Alternativ kann die Metallisierung innerhalb eines Mehrschichtsubstrats angeordnet sein, wobei nach außen hin eine isolierende Schicht angeordnet ist.

Zusätzlich kann zumindest eine passive Komponente in das Substrat integriert sein. Alternativ oder ergänzend können zumindest eine passive Komponente und/oder eine aktive Komponente auf einer Oberfläche des Substrats angeordnet sein. Die Ansteuerschaltung kann vollständig oder teilweise durch eine oder mehrere passive Komponenten, die in das Substrat integriert sind oder auf der Oberfläche des Substrats angeordnet sind, und/oder eine oder mehrere aktive Komponenten, die auf der Oberfläche des Substrats angeordnet sind, ausgebildet sein. Durch die Integration der Komponenten in das Substrat bzw. die Anordnung der Komponenten auf der Oberfläche des Substrats kann eine kompakte Bauweise der Vorrichtung ermöglicht werden. Im Hinblick auf übliche Anforderungen bezüglich einer Miniaturisierung ist eine derartige kompakte Bauweise vorteilhaft.

Die Feldsonde kann zumindest drei voneinander getrennte Metallisierungen aufweist, die je einen Messpunkt bilden, wobei die zumindest drei Metallisierungen in einer Reihe angeordnet sind. Die Feldsonde kann derart angeordnet sein, dass die Reihe parallel zu dem piezoelektrischen Transformator angeordnet ist.

Die Vorrichtung kann ferner eine Auswerteelektronik zur Weiterverarbeitung von von der Feldsonde erfassten Messwerten aufweisen. Die Auswerteelektronik kann mit der Ansteuerschaltung verbunden sein. Die Auswerteelektronik kann einen Signalkonditionierer und eine Signalverarbeitungseinheit aufweisen. Die Ansteuerschaltung sowie deren Funktionen werden ganz oder teilweise über eine Softwarelösung realisiert. Dies kann auch für die Weiterverarbeitung der Signale und die Auswerteelektronik gelten.

Die Ansteuerschaltung kann dazu ausgestaltet sein, das an den piezoelektrischen Transformator angelegte Eingangssignal an die Auswerteelektronik zu übermitteln, wobei die Auswerteelektronik dazu ausgestaltet ist, aus den von der Feldsonde erfassten Messwerten das vom piezoelektrischen Transformator ermittelte Ausgangssignal zu ermitteln, und wobei die Auswerteelektronik dazu ausgestaltet ist, das Eingangssignal mit dem Ausgangssignal zu vergleichen.

Bei dem Vergleich des Eingangssignals mit dem Ausgangssignal kann eine Spannung der Signale und/oder eine Stromstärke der Signale und/oder eine Impedanz und/oder eine Frequenz der Signale und/oder eine Phase der Signale betrachtet werden. Bei dem Vergleich des Eingangssignals mit dem Ausgangssignal kann eine Parallelresonanzfrequenz des piezoelektrischen Transformators und/oder eine Serienresonanzfrequenz ermittelt werden. Die Serienresonanzfrequenz zeichnet sich durch eine maximale Feldstärke an der Feldsonde bei gleichzeitig minimalem Strom des Eingangssignals aus. Die Serienresonanzfrequenz könnte somit auch anhand eines einzigen Messpunkts ermittelt werden. Zur Ermittlung der Parallelresonanzfrequenz sind dagegen zumindest zwei, bevorzugt mehrere Messpunkte erforderlich.

Die Auswerteelektronik kann vollständig oder teilweise durch eine oder mehrere passive Komponenten, die in das Substrat integriert sind oder auf der Oberfläche des Substrats angeordnet sind, und/oder eine oder mehrere aktive Komponenten, die auf der Oberfläche des Substrats angeordnet sind, ausgebildet sein.

Die Auswerteelektronik kann dazu ausgestaltet sein, anhand einer Veränderung der Feldstärke eine vor der ausgangsseitigen Stirnseite des piezoelektrischen Transformators angeordnete Last zu erkennen, wobei die Ansteuerschaltung derart ausgestaltet ist, dass nur dann eine zur Zündung eines nichtthermisches Atmosphärendruck-Plasmas ausreichende Leistung an den Eingangsbereich des piezoelektrischen Transformators angelegt wird, wenn vor der ausgangsseitigen Stirnseite eine Last erkannt ist. Ferner kann es möglich sein an die Last die optimale Leistung abzugeben und/oder diese optimal anzupassen.

Durch die Messung der Feldstärke an mehreren, zumindest zwei, verschiedenen Messpunkten und durch den Vergleich des Eingangssignals mit dem Ausgangssignal kann es ermöglicht werden, eine vor dem Transformator angeordnete Last quantitativ und qualitativ zu erkennen. Da die Last einen erheblichen Einfluss auf das vom Transformator erzeugte elektrische Feld haben kann, kann durch das Erkennen und Berücksichtigen der Last bei der Ansteuerung des Transformators eine verbesserte Funktion des Transformators erreicht werden. Wird keine Last erkannt, kann die Leistung des Eingangssignals auf einen geringen Wert eingestellt werden, so dass kein Plasma gezündet wird.

Die Vorrichtung kann ferner eine zweite Feldsonde aufweisen, die dazu ausgestaltet ist, eine Feldstärke eines von dem piezoelektrischen Transformator erzeugten elektrischen Feldes an zumindest zwei Messpunkten zu messen. Der Transformator kann beispielsweise zwischen den beiden Feldsonden angeordnet sein. Die zweite Feldsonde kann baugleich zur ersten Feldsonde sein oder eine andere Form als die erste Feldsonde aufweisen.

Zusätzlich kann die Feldsonde mit Messeinrichtungen für beispielsweise einen Luftdruck, eine Temperatur, eine Feuchte, eine Leitfähigkeit, eine Ozonkonzentration, eine Gaszusammensetzung, eine Ionenkonzentration und/oder eine Partikelkonzentration kombiniert sein.

Die Ansteuerschaltung kann ferner dazu ausgestaltet sein, bei der Anpassung des Eingangssignals neben den von der Feldsonde ermittelten Messwerten zumindest eines ausgewählt aus einem Druck, einer Temperatur, einer Feuchte, eine Leitfähigkeit, eine Ozonkonzentration, eine Gaszusammensetzung, eine Ionenkonzentration und/oder eine Partikelkonzentration zu berücksichtigen. Dabei kann es sich insbesondere um den von der Feldsonde mittels der oben genannten Messeinrichtung ermittelten Parameter ausgewählt aus einem Druck, einer Temperatur, einer Feuchte, eine Leitfähigkeit, eine Ozonkonzentration, eine Gaszusammensetzung, eine Ionenkonzentration und/oder eine Partikelkonzentration handeln.

Der piezoelektrische Transformator kann dazu ausgestaltet sein, an seiner ausgangsseitigen Stirnseite ein Plasma zu zünden. Die Ansteuerschaltung kann dazu ausgestaltet sein, im laufenden Betrieb der Vorrichtung in festgelegten zeitlichen Abständen unter Berücksichtigung der Messergebnisse der Feldsonde eine Korrektur des Eingangssignals vorzunehmen. Alternativ kann dies kontinuierlich und/oder in Echtzeit erfolgen.

Die Vorrichtung kann zur Erzeugung von angeregten Molekülen, Ionen oder Radikalen dienen, insbesondere zur Erzeugung von OH-Radikalen und/oder Stickoxid und/oder Ozon.

Ein weiterer Aspekt betrifft ein Verfahren zum Betrieb eines piezoelektrischen Transformators. Es kann sich dabei um den piezoelektrischen Transformator der oben beschriebenen Vorrichtung handeln. Dementsprechend können die strukturellen und funktionalen Merkmale, die im Zusammenhang mit der Vorrichtung beschrieben sind, auch auf den Transformator zutreffen.

Das Verfahren kann die folgenden Schritte umfassen:
- Anlegen eines Eingangssignals an den piezoelektrischen Transformator,
- Messen der Feldstärke eines von dem piezoelektrischen Transformator erzeugten elektrischen Feldes durch eine Feldsonde an einem Messpunkt, bevorzugt an zumindest zwei Messpunkten,
- Anpassen des an den piezoelektrischen Transformator angelegten Eingangssignals unter Berücksichtigung der Messwerte durch eine Ansteuerschaltung, wobei die Ansteuerschaltung ganz oder teilweise durch Software realisiert ist ,
wobei der piezoelektrische Transformator zur Erzeugung eines nicht-thermischen Atmosphärendruck-Plasmas eingesetzt wird.

Eine Frequenz des Eingangssignals kann schrittweise geändert werden und die Frequenz bestimmt werden, bei der sich ein Maximum in der Feldstärke an der ausgangsseitigen Stirnseite des Transformators oder in einem vom piezoelektrischen Transformator wegweisenden Halbraum vor der ausgangsseitigen Stirnseite des piezoelektrischen Transformators einstellt, wobei die Frequenz des Eingangssignals anschließend auf die ermittelte Frequenz eingestellt wird.

Das Verfahren kann ferner die folgenden Schritte aufweisen:
- Übermitteln des Eingangssignal an eine Auswerteelektronik,
- Ermitteln eines Ausgangssignal des piezoelektrischen Transformators aus den von der Feldsonde erfassten Messwerten durch die Auswerteelektronik, und
- Vergleichen des Eingangssignals mit dem Ausgangssignal durch die Auswerteelektronik.

Diese Schritte des Verfahrens können auch ganz oder teilweise über Software erfolgen.

Bei dem Vergleich des Eingangssignals mit dem Ausgangssignal kann eine Parallelresonanzfrequenz des piezoelektrischen Transformators ermittelt werden, und die Frequenz des Eingangssignals auf die Parallelresonanzfrequenz eingestellt wird. Alternativ könnte die Serienresonanzfrequenz ermittelt werden und die Frequenz des Eingangssignals auf die Serienresonanzfrequenz eingestellt werden.

Zusätzlich oder alternativ kann das Eingangssignal anhand der von weiteren Messfühlern ausgelesenen und ausgewerteten Messsignale eingestellt und/oder an gewisse Betriebszustände angepasst werden. Dabei können die weiteren Messfühler beispielsweise einen Druck, eine Temperatur und/oder eine Ozonkonzentration ermitteln.

Der piezoelektrische Transformator kann zur Erzeugung eines nicht-thermischen Atmosphärendruck-Plasmas eingesetzt werden. Das Plasma kann zur Erzeugung von angeregten Molekülen, Ionen oder Radikalen genutzt wird.

Durch einen Vergleich der von der Feldsonde ermittelten Messwerte mit einem Referenzsignal kann eine Kalibration des piezoelektrischen Transformators und oder eine Bestimmung einer Alterung und/oder einer Lebensdauer des piezoelektrischen Transformators vorgenommen werden.

Im Folgenden werden bevorzugte Ausführungsbeispiele der Erfindung anhand der Figuren näher erläutert.
Figur 1 zeigt einen piezoelektrischen Transformator 1 in einer perspektivischen Ansicht.
Figur 2 zeigt eine Vorrichtung zur Erzeugung eines nicht-thermischen Atmosphärendruckplasmas.
Figuren 3, 4 und 5 zeigen jeweils eine Feldsonde 12 gemäß einem ersten Ausführungsbeispiel.
Figuren 6, 7 und 8 zeigen eine Feldsonde 12 gemäß einem zweiten Ausführungsbeispiel.
Figur 9 zeigt ein erstes Signal, das als Eingangssignal an den piezoelektrischen Transformator 1 angelegt werden kann.
Figur 10 zeigt von der Feldsonde ermittelte Messwerte.
Figur 11 zeigt ein zweites Eingangssignal, das an den piezoelektrischen Transformator 1 angelegt werden kann.
Figur 12 zeigt für verschiedene an den piezoelektrischen Transformator angelegte Signale jeweils die Messwerte, die von den einzelnen Messpunkten der Feldsonde für die Feldstärke ermittelt werden.

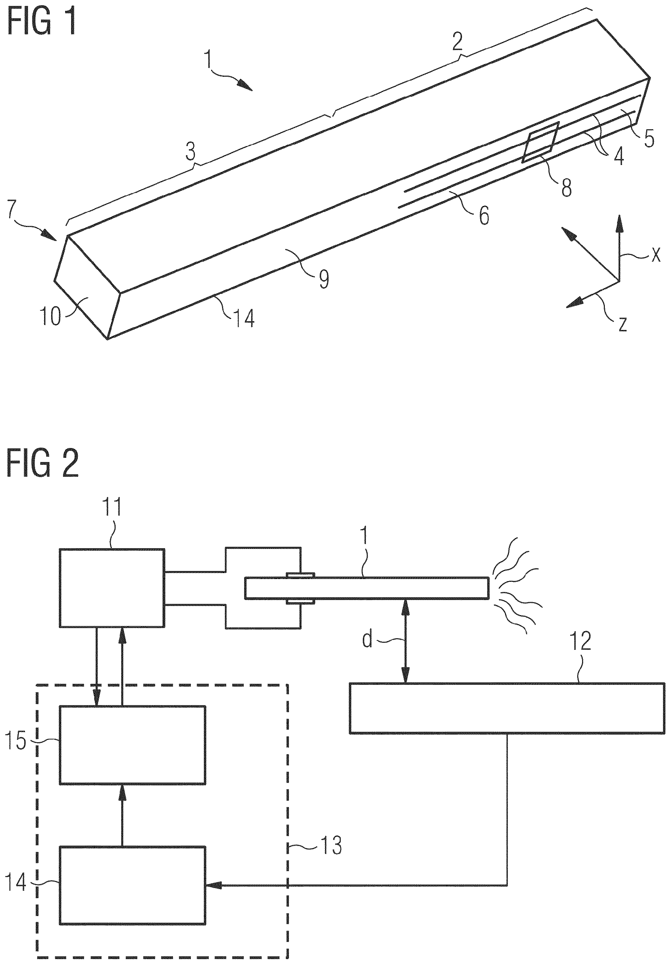

Figur 1 zeigt einen piezoelektrischen Transformator 1 in einer perspektivischen Ansicht. Der piezoelektrische Transformator 1 kann insbesondere in einem Plasmagenerator zur Erzeugung von nichtthermischem Atmosphärendruck-Plasma eingesetzt werden.

Ein piezoelektrischer Transformator 1 ist eine Bauform eines Resonanztransformators, welcher auf Piezoelektrizität basiert und im Gegensatz zu den herkömmlichen magnetischen Transformatoren ein elektromechanisches System darstellt. Der piezoelektrische Transformator 1 ist beispielsweise ein Transformator vom Rosen-Typ.

Der piezoelektrische Transformator 1 weist einen Eingangsbereich 2 und einen Ausgangsbereich 3 auf, wobei der Ausgangsbereich 3 sich in einer Längsrichtung z an den Eingangsbereich 2 anschließt. Im Eingangsbereich 2 weist der piezoelektrische Transformator 1 Elektroden 4 auf, an die eine Wechselspannung angelegt werden kann. Die Elektroden 4 erstrecken sich in der Längsrichtung z des piezoelektrischen Transformators 1. Die Elektroden 4 sind in einer Stapelrichtung x, die senkrecht zu der Längsrichtung z ist, abwechselnd mit einem piezoelektrischen Material 5 gestapelt.

Das piezoelektrische Material 5 ist dabei in Stapelrichtung x polarisiert.

Die Elektroden 4 sind im Innern des piezoelektrischen Transformators 1 angeordnet und werden auch als Innenelektroden bezeichnet. Der piezoelektrische Transformator 1 weist eine erste Seitenfläche 6 und eine zweite Seitenfläche 7, die der ersten Seitenfläche 6 gegenüberliegt, auf. Auf der ersten Seitenfläche 6 ist eine erste Außenelektrode 8 angeordnet. Auf der zweiten Seitenfläche 7 ist eine zweite Außenelektrode (nicht gezeigt) angeordnet. Die innenliegenden Elektroden 4 sind in Stapelrichtung x abwechselnd entweder mit der ersten Außenelektrode 8 oder der zweiten Außenelektrode elektrisch kontaktiert.

Der Eingangsbereich 2 kann mit einer geringen Wechselspannung angesteuert werden, die zwischen den Elektroden 4 angelegt wird. Aufgrund des piezoelektrischen Effekts wird die eingangsseitig angelegte Wechselspannung zunächst in eine mechanische Schwingung umgewandelt. Die Frequenz der mechanischen Schwingung ist dabei wesentlich von der Geometrie und dem mechanischen Aufbau des piezoelektrischen Transformators 1 abhängig.

Der Ausgangsbereich 3 weist piezoelektrisches Material 9 auf und ist frei von innenliegenden Elektroden. Das piezoelektrische Material 9 im Ausgangsbereich 3 ist in der Längsrichtung z polarisiert. Bei dem piezoelektrischen Material 9 des Ausgangsbereichs 3 kann es sich um das gleiche Material wie bei dem piezoelektrischen Material 5 des Eingangsbereichs 2 handeln, wobei sich die piezoelektrischen Materialien 5 und 9 in ihrer Polarisationsrichtung unterscheiden können. Im Ausgangsbereich 3 ist das piezoelektrische Material 9 zu einer einzigen monolithischen Schicht geformt, die vollständig in der Längsrichtung z polarisiert ist. Dabei weist das piezoelektrische Material 9 im Ausgangsbereich 3 nur eine einzige Polarisationsrichtung auf.

Wird an die Elektroden 4 im Eingangsbereich 2 eine Wechselspannung angelegt, so bildet sich innerhalb des piezoelektrischen Materials 5, 9 eine mechanische Welle aus, die durch den piezoelektrischen Effekt im Ausgangsbereich 3 eine Ausgangsspannung erzeugt. Der Ausgangsbereich 3 weist eine ausgangsseitige Stirnseite 10 auf. Im Ausgangsbereich 3 wird somit eine elektrische Spannung zwischen der Stirnseite 10 und dem Ende der Elektroden 4 des Eingangsbereichs 2 erzeugt. An der ausgangsseitigen Stirnseite 10 wird dabei eine Hochspannung erzeugt. Dabei entsteht auch zwischen der ausgangseitigen Stirnseite und einer Umgebung des piezoelektrischen Transformators eine hohe Potentialdifferenz, die ausreicht, um ein starkes elektrisches Feld zu erzeugen, dass ein Prozessgas ionisiert.

Auf diese Weise erzeugt der piezoelektrische Transformator 1 hohe elektrische Felder, die in der Lage sind, Gase oder Flüssigkeiten durch elektrische Anregung zu ionisieren. Dabei werden Atome oder Moleküle des jeweiligen Gases bzw. der jeweiligen Flüssigkeit ionisiert und bilden ein Plasma. Es kommt immer dann zu einer Ionisation, wenn die elektrische Feldstärke an der Oberfläche des piezoelektrischen Transformators 1 die Zündfeldstärke des Plasmas überschreitet. Als Zündfeldstärke eines Plasmas wird dabei die Feldstärke bezeichnet, die zur Ionisation der Atome oder Moleküle erforderlich ist.

Figur 2 zeigt eine Vorrichtung zur Erzeugung eines nicht-thermischen Atmosphärendruckplasmas, die den im Zusammenhang mit Figur 1 beschriebenen piezoelektrischen Transformator 1 aufweist. Die Vorrichtung weist ferner eine Ansteuerschaltung 11 auf, die dazu ausgelegt ist, ein Eingangssignal an den piezoelektrischen Transformator 1 anzulegen, eine Feldsonde 12, die ein vom piezoelektrischen Transformator 1 erzeugtes Feld vermisst, und eine Auswerteelektronik 13, die mit der Feldsonde 12 und der Ansteuerschaltung 11 verbunden ist, auf.

Ein Ziel der vorliegenden Erfindung ist es, es zu ermöglichen, das Eingangssignal stets so anzupassen, dass der piezoelektrische Transformator 1 bei seiner aktuellen Serienresonanzfrequenz oder bei seiner aktuellen Parallelresonanzfrequenz betrieben wird. Die Serienresonanzfrequenz und die Parallelresoanzfrequenz des Transformators 1 sind nicht konstant, sondern hängen von verschiedenen Parametern ab. Wird an einer ausgangsseitigen Stirnseite 10 des Transformators 1 ein Plasma gezündet, so wirkt dieses als Last mit dem Transformator 1 zusammen und beeinflusst dabei die Impedanz des Transformators 1. Dadurch kommt es zu einer Verschiebung der Serienresonanz und der Parallelresonanzfrequenz gegenüber einem Betrieb des Transformators 1 im Leerlauf, bei dem die angelegte Spannung zur Zündung eines Plasmas nicht ausreicht. Auch die Arbeitsumgebungen, beispielsweise das verwendete Prozessgas oder die Temperatur des Transformators 1, beeinflussen die Serienresonanzfrequenz und die Parallelresonanzfrequenz.

Die Ansteuerschaltung 11 legt an den piezoelektrischen Transformator 1 das Eingangssignal an. Das Eingangssignal ist vorzugsweise sinusförmig. Es sind jedoch auch Eingangssignale mit einer anderen Form, beispielsweise rechteckig oder dreieckig, möglich. Das Eingangssignal, das von der Ansteuerschaltung 11 erzeugt wird, wird gemäß einem von der Auswerteelektronik 13 an die Ansteuerschaltung 11 übermittelten Feedbacksignals laufend angepasst.

Die Feldsonde 12 ist dazu ausgestaltet, eine Feldstärke des von dem piezoelektrischen Transformator 1 erzeugten elektrischen Feldes zu messen. Die Feldsonde 12 ist in unmittelbarer Nähe zu dem Ausgangsbereich 3 des piezoelektrischen Transformators 1 angeordnet. Insbesondere ist die Feldsonde 12 dazu ausgestaltet, die lokale Feldstärke des vom piezoelektrischen Transformator 1 erzeugten elektrischen Feldes an mehreren Messpunkten zu ermitteln. Dementsprechend kann ein räumlicher Verlauf der Feldstärke des elektrischen Feldes durch die Feldsonde 12 ermittelt werden. Dabei kann es die Feldsonde 12 ermöglichen, zu bestimmen, an welcher Position eine maximale Feldstärke vorliegt.

Die Ausgestaltung des elektrischen Feldes und der Ort der maximalen Feldstärke hängen von dem an den Transformator 1 angelegten Eingangssignal und von den Betriebsbedingungen des piezoelektrischen Transformators 1 ab. Hinsichtlich des Eingangssignals sind dabei die folgenden Parameter für die Ausbildung des Feldes wesentlich: eine Eingangsspannung, eine Stromstärke eines Eingangsstroms, eine Phasenbeziehung zwischen der Eingangsspannung und den Eingangsstrom und eine Frequenz des Eingangssignals. Hinsichtlich der Betriebsbedingungen kann das elektrische Feld von einem Prozessmedium, einer Umgebungstemperatur und/oder einer Luftfeuchtigkeit beeinflusst werden. Ferner beeinflusst auch eine in der Nähe des Transformators 1 angeordnete Last die Potentialverteilung des elektrischen Feldes und somit den Ort der maximalen Feldstärke.

Die Auswerteelektronik 13 ist dazu ausgestaltet, die Messwerte, die von der Feldsonde 12 ermittelt werden, auszuwerten und ist ferner dazu ausgestaltet, die Ansteuerschaltung 11 zu steuern. Die Auswerteelektronik 13 weist einen Signalkonditionierer 14 und eine Signalverarbeitungseinheit 15 auf.

Die Feldsonde 12 übermittelt ein Messsignal an die Auswerteelektronik 13. In der Auswerteelektronik 13 wird das Messsignal zunächst von dem Signalkonditionierer 14 bearbeitet. Insbesondere kann der Signalkonditionierer 14 das Messsignal filtern, in ein digitales Signal umwandeln, verstärken und/oder entzerren. Das von dem Signalkonditionierer 14 weiterverarbeitete Signal wird dann an die Signalverarbeitungseinheit 15 weitergegeben. Die Signalverarbeitungseinheit 15 verarbeitet das Signal und ermittelt ein Feedbacksignal, das an die Ansteuerschaltung 11 übermittelt wird.

Die Signalverarbeitungseinheit 14 kann dabei das Eingangssignal, das von der Ansteuerschaltung 11 an den piezoelektrischen Transformator 1 angelegt wird, und ein Ausgangssignal des Transformators 1 miteinander vergleichen. Zu diesem Zweck kann das von der Ansteuerschaltung 11 an den piezoelektrischen Transformator 1 angelegte Eingangssignal auch an die Signalverarbeitungseinheit 14 übermittelt werden. Das Ausgangssignal des Transformators 1 wird von der Signalverarbeitungseinheit 14 anhand der von der Feldsonde 12 aufgezeichneten Messwerte ermittelt. Alternativ kann das Ausgangsignal in der Signalverarbeitungseinheit 14 auch mit einem Referenzsignal verglichen werden. Dies kann zur Kalibrierung der Vorrichtung und/oder zur Bestimmung des Alterungsgrades des piezoelektrischen Transformators 1 und/oder zur Lebensdauerüberwachung des piezoelektrischen Transformators 1 dienen.

Bei dem Vergleich des Eingangssignals mit dem Ausgangssignal kann eine Spannung der beiden Signale miteinander verglichen werden. Alternativ oder ergänzend, kann bei dem Vergleich des Eingangssignals mit dem Ausgangssignal eine Stromstärke der beiden Signale miteinander verglichen werden. Alternativ oder ergänzend, kann bei dem Vergleich des Eingangssignals mit dem Ausgangssignal eine Phasenbeziehung zwischen der Spannung und der Stromstärke der beiden Signale miteinander verglichen werden. Alternativ oder ergänzend, kann bei dem Vergleich des Eingangssignals mit dem Ausgangssignal eine Frequenz der beiden Signale miteinander verglichen werden. Alternativ oder ergänzend, kann bei dem Vergleich des Eingangssignals mit dem Ausgangssignal eine Impedanz des Transformators berücksichtigt werden. Durch die Betrachtung eines oder mehrerer der hier genannten Parameter bei dem Vergleich der Signale kann die Auswerteelektronik 13 die aktuelle Parallelresonanzfrequenz und/oder die aktuelle Serienresonanzfrequenz des Transformators 1 ermitteln. Die Auswerteelektronik 13 übermittelt dann ein Feedbacksignal an die Ansteuerschaltung 11, das die Ansteuerschaltung 11 dazu veranlasst, die Frequenz des Eingangssignals anzupassen und auf die aktuelle Parallelresonanzfrequenz oder die aktuelle Serienresonanzfrequenz des Transformators 1 einzustellen. Dieser Vorgang kann im laufenden Betrieb der Vorrichtung in regelmäßigen zeitlichen Abständen oder kontinuierlich in Echtzeit wiederholt werden.

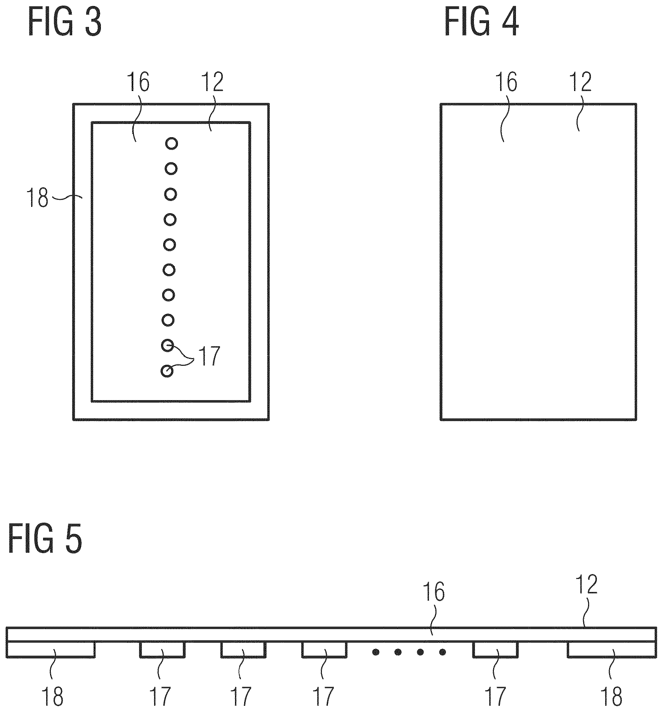

Die Figuren 3, 4 und 5 zeigen jeweils eine Feldsonde 12 gemäß einem ersten Ausführungsbeispiel. Figur 3 zeigt dabei eine Unterseite der Feldsonde 12, die von dem piezoelektrischen Transformator 1 weg weist. Figur 4 zeigt eine Oberseite der Feldsonde 12, die zu dem piezoelektrischen Transformator hinweist. Figur 5 zeigt einen Querschnitt durch die Feldsonde 12.

Die Feldsonde 12 weist ein Substrat 16 aus einem isolierenden Material auf. Bei dem isolierenden Material kann es sich beispielsweise um ein Polymer, ein keramisches Material, FR4, Glas oder Al₂O₃ handeln. Gemäß dem ersten Ausführungsbeispiel ist das Substrat 16 einlagig.

Auf einer Unterseite des Substrats 16, die von dem piezoelektrischen Transformator 1 weg weist, sind Metallisierungen 17 ausgebildet. Gemäß dem ersten Ausführungsbeispiel sind die Metallisierungen 17 kreisförmig. Denkbar sind auch andersförmige Metallisierungen 17, beispielsweise rechteckige Metallisierungen. Jede der Metallisierungen 17 bildet einen Messpunkt, an dem die Feldsonde 12 eine lokale Feldstärke des elektrischen Feldes, das von dem piezoelektrischen Transformator 1 erzeugt wird, ermittelt. Die Messpunkte sind in einer Reihe angeordnet.

Die Feldsonde 12 ist in einem Abstand d zu dem piezoelektrischen Transformator 1 angeordnet, der groß genug ist, um Plasmazündungen des Transformators 1 gegen die Feldsonde 12 zu vermeiden. Der Abstand d kann ferner so gewählt werden, das Funken eines vom Transformator 1 erzeugten Plasmastrahls die Feldsonde 12 nicht erreichen.

Die Feldsonde 12 ist parallel zu dem Ausgangsbereich 3 des piezoelektrischen Transformators 1 angeordnet sind und ragt über den Ausgangsbereich 3 hinaus. Die Feldsonde 12 kann dementsprechend die Feldstärke im Ausgangsbereich 3 und in einem von dem Transformator 1 wegweisenden Halbraum vor der ausgangsseitigen Stirnseite 10 des piezoelektrischen Transformators 1 messen.

Ferner weist die Feldsonde 12 eine Metallfläche 18 auf, an der ein Referenzpotential anliegt. Die Metallfläche 18 bildet einen Rahmen und ist an den Rändern der Unterseite der Feldsonde 12 angeordnet. Die von den Messpunkten gebildete Reihe wird durch die Metallfläche 18 umrahmt. Zur Bestimmung einer lokalen Feldstärke wird jeweils die Spannung zwischen dem jeweiligen Messpunkt und der Metallfläche 18 ermittelt. Zu diesem Zweck ist die Metallfläche 18 mit dem Referenzpotential verbunden sein. Denkbar sind auch andersförmige Metallflächen 18. Beispielsweise könnte die Metallfläche 18 statt einen umlaufenden Rahmen zu bilden auch U- oder Π-förmig sein.

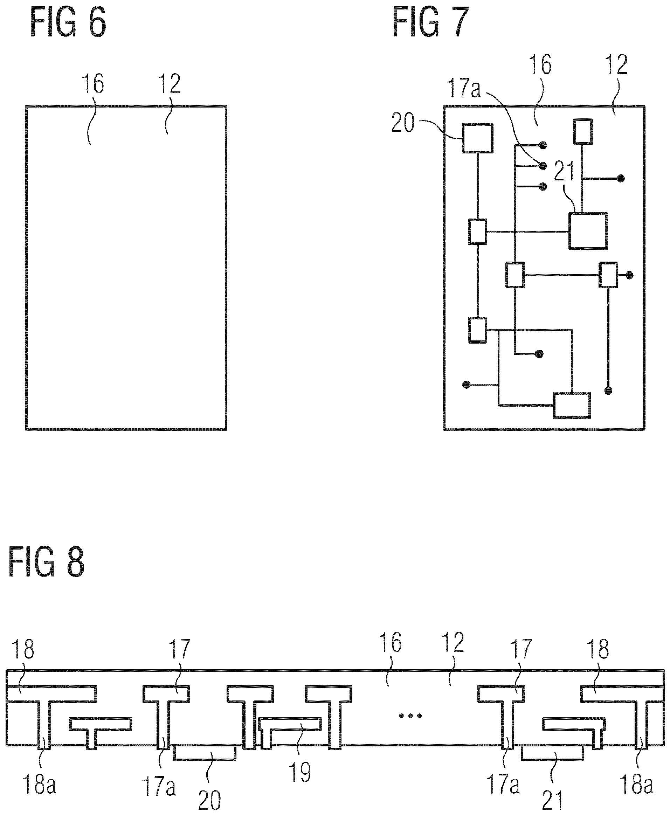

Die Figuren 6, 7 und 8 zeigen eine Feldsonde 12 gemäß einem zweiten Ausführungsbeispiel. Dabei zeigt Figur 6 eine Oberseite der Feldsonde 12, die dem piezoelektrischen Transformator 1 zugewandt ist. Figur 7 zeigt eine Unterseite der Feldsonde 12, die von dem piezoelektrischen Transformator 1 weg weist. Figur 8 zeigt einen Querschnitt durch die Feldsonde 12.

Gemäß dem zweiten Ausführungsbeispiel ist das Substrat 16 der Feldsonde 12 mehrlagig. Die Metallisierungen 17, die die Messpunkte ausbilden, sind in einer inneren Schicht des Substrats 16 angeordnet. Ferner weisen die Metallisierungen 17 Durchkontaktierungen 17a auf, die zu der Unterseite der Feldsonde 12 durchgeführt sind. Auch der Rahmen, der durch die Metallfläche 18 gebildet wird, ist in der inneren Schicht des mehrlagigen Substrats 16 ausgebildet und weist eine Durchkontaktierung 18a auf. An den Durchkontaktierungen 17a, 18a kann ein Potential der Metallfläche 18 und der Metallisierungen 17 abgegriffen werden.

Ferner sind passive Komponenten 19 in das mehrlagige Substrat 16 der Feldsonde 12 integriert. Auf der Unterseite der Feldsonde 12 ist eine weitere passive Komponente 20 angeordnet. Ferner ist auch eine aktive Komponente 21 auf der Unterseite der Feldsonde 12 angeordnet. Bei den aktiven und passiven Komponenten 19, 20, 21 handelt es sich um Komponenten der Ansteuerschaltung 11 und/oder der Auswerteelektronik 13. Insbesondere können die Auswerteelektronik 13 und/oder die Ansteuerschaltung 11 jeweils vollständig oder teilweise auf der Feldsonde 12 ausgebildet sein.

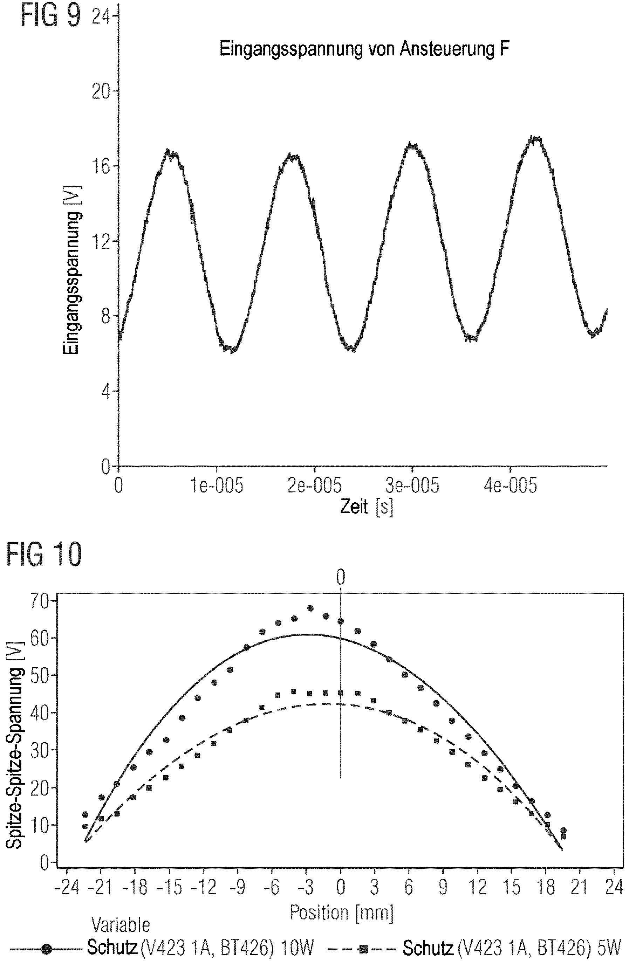

Figur 9 zeigt ein erstes Signal, das als Eingangssignal von der Ansteuerschaltung 11 an den piezoelektrischen Transformator 1 angelegt werden kann. Das Signal ist im Wesentlichen sinusförmig.

Figur 10 zeigt die von der Feldsonde 12 ermittelten Messwerte für die Feldstärke an verschiedenen Positionen in der Nähe des piezoelektrischen Transformators 1. Die Feldsonde 12 ist dabei derart angeordnet, dass die Messpunkte parallel zu dem Ausgangsbereich 3 und in einem Bereich vor der ausgangsseitigen Stirnseite 10 angeordnet sind.

In Figur 10 ist auf der Ordinatenachse jeweils die von der Feldsonde 12 an den einzelnen Messpunkten ermittelte Feldstärke in Volt aufgetragen. Auf der Abszissenachse ist die Position der Messpunkte aufgetragen, wobei die Position 0 der ausgangsseitigen Stirnseite 10 entspricht. Der Ausgangsbereich 3 des piezoelektrischen Transformators 1 verläuft dabei in positiver Richtung. Dementsprechend ist beispielsweise die Position "3 mm" im Ausgangsbereich 3 des Transformators 1 angeordnet und befindet sich im Abstand von 3 mm zur ausgangsseitigen Stirnseite 10. Die Position "-3 mm" befindet sich vor der ausgangsseitigen Stirnseite 10 im Abstand von 3 mm zu dieser.

Figur 10 zeigt den Verlauf der Feldstärke für zwei unterschiedliche Eingangssignale, die jeweils die in Figur 9 gezeigte im Wesentlichen sinusförmige Form aufweisen. Die Leistung des ersten Eingangssignals beträgt 10 W. Die Leistung des zweiten Eingangssignals beträgt 5 W. In Figur 10 ist zu erkennen, dass sich für das erste Eingangssignal ein Maximum der elektrischen Feldstärke im Abstand von etwa 4 mm vor der ausgangsseitigen Stirnseite 10 ausbildet. Für das zweite Eingangssignal mit einer Leistung von 5 W bildet sich dagegen in der Verteilung der elektrischen Feldstärke ein Plateau einer maximalen Feldstärke, das von einem Randbereich des Eingangsbereiches bis zu einem Abstand von etwa 6 mm vor der ausgangsseitigen Stirnseite 10 reicht. Diese Messung zeigt somit, dass die Leistung des Eingangssignals wesentlich für die räumliche Anordnung des Maximums der Feldstärke ist.

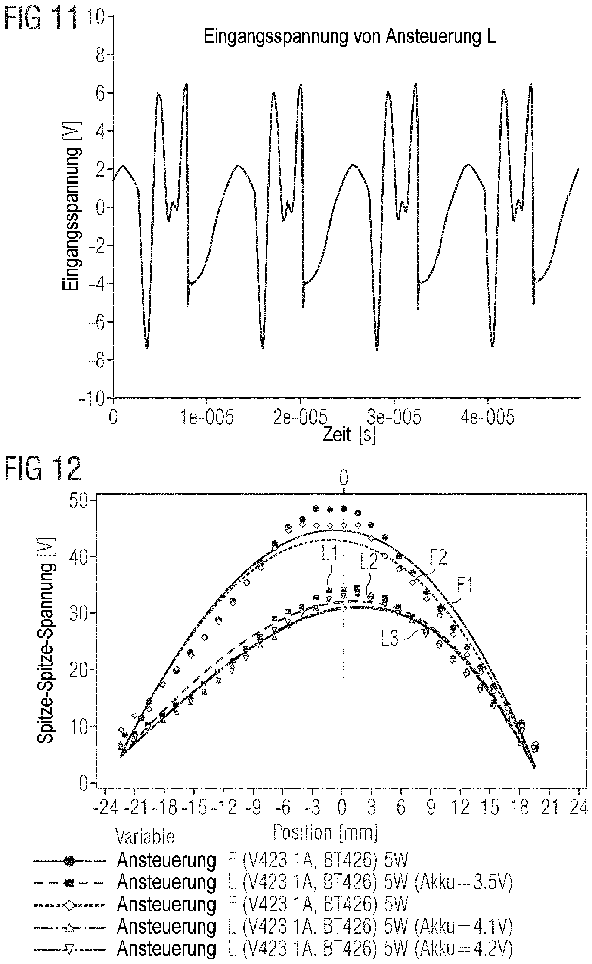

Figur 11 zeigt ein zweites Eingangssignal, das von der Ansteuerschaltung 11 an den piezoelektrischen Transformator 1 angelegt werden kann. Das zweite Eingangssignal weist einen periodischen Verlauf auf, es bildet jedoch keine regelmäßige Sinuskurve.

Figur 12 zeigt für verschiedene an den piezoelektrischen Transformator 1 angelegte Signale jeweils die Messwerte, die von den einzelnen Messpunkten der Feldsonde für die Feldstärke ermittelt werden. Sämtliche angelegte Signale weisen dabei eine Eingangsleistung von 5 W auf. Die Kurven F1 und F2 entsprechen einem angelegten ersten Signal, dessen Verlauf in Figur 9 gezeigt ist, und die Kurven L1, L2 und L3 entsprechen einem angelegten zweiten Signal, dessen Verlauf in Figur 11 gezeigt ist.

Figur 12 zeigt, dass bei dem zweiten Eingangssignal sich ein Maximum in der Feldstärke ausbildet, das im Ausgangsbereich 3 des piezoelektrischen Transformators 1 in einen Abstand von wenigen Millimetern von der ausgangsseitigen Stirnseite liegt. Ein solches Maximum ist ungünstig, da dieses zu Plasmazündungen entlang der Kanten des Ausgangsbereichs 3 führen kann, durch die der piezoelektrische Transformator 1 beschädigt werden kann.

Ein Betrieb des Transformators 1 mit dem zweiten Eingangssignal ist möglich, dabei sollten das Eingangssignal derart angepasst werden, dass das Maximum der Feldstärke hin zu der ausgangsseitigen Stirnseite 10 verschoben wird. Zu diesem Zweck kann beispielsweise die Frequenz des Eingangssignals angepasst werden. Auch eine vor der ausgangsseitigen Stirnseite 10 angeordnete Last führt zu einer Veränderung des Feldes.

Die Feldsonde 12 ermöglicht es somit den räumlichen Verlauf des vom piezoelektrischen Transformator 1 erzeugten elektrischen Feld aufzuzeichnen, da die Feldsonde 12 die Feldstärke an mehreren Messpunkten gleichzeitig aufzeichnet. Dadurch kann, wie im Zusammenhang mit Figur 12 gezeigt, der Einfluss von verschiedenen Signalformen des Eingangssignals auf den Potentialverlauf des erzeugten Feldes gemessen werden. Es ist ferner möglich mit einer derartigen Feldsonde 12 den Einfluss von unterschiedlichen Arbeitsbedingungen auf den Potentialverlauf des erzeugten Feldes zu messen, wobei die Arbeitsbedingungen sich beispielsweise hinsichtlich Temperatur, Luftfeuchtigkeit oder dem verwendeten Prozessmedium unterscheiden können. Es ist ferner möglich mit einer derartigen Feldsonde 12 den Effekt einer Alterung des Transformators 1 aufzuzeigen, wobei Veränderungen des elektrischen Feldes über eine Lebensdauer des Transformators 1 gemessen werden können.

Eine Auswertung der von der Feldsonde 12 erfassten Messwerte ermöglicht es, quantitative und qualitative Angaben zu einer vor dem Transformator 1 angeordneten Last zu treffen. Insbesondere könnte die Auswerteelektronik 13 dazu ausgestaltet sein, anhand der von der Feldsonde 12 erfassten Messwerte und des Vergleichs des Eingangssignals mit dem Ausgangssignal zu bestimmen, ob eine Last vor dem piezoelektrischen Transformator 1 angeordnet ist. Wird keine Last erkannt, so kann die Auswerteelektronik 13 ein Feedbacksignal an die Ansteuerschaltung 11 senden, gemäß dem die Leistung des Eingangssignals soweit reduziert wird, dass es nicht zu Plasmazündungen kommt. Wird eine Last erkannt, so kann die Auswerteelektronik 13 ein Feedbacksignal an die Ansteuerschaltung 11 senden, gemäß eine Leistung des Eingangssignals eingestellt wird, die zur Zündung von Plasma ausreicht. Dementsprechend kann das Plasma nur dann gezündet werden, wenn eine vor dem Transformator 1 angeordnete Last erkannt wird.

Die Feldsonde 12 kann in eine Halterung integriert sein, in der der piezoelektrische Transformator 1 mechanisch befestigt ist und über die der piezoelektrische Transformator 1 elektrisch kontaktiert ist.

### Bezugszeichenliste

- 1: piezoelektrischer Transformator
- 2: Eingangsbereich
- 3: Ausgangsbereich
- 4: Elektrode
- 5: piezoelektrisches Material
- 6: erste Seitenfläche
- 7: zweite Seitenfläche
- 8: Außenelektrode
- 9: piezoelektrisches Material
- 10: ausgangsseitige Stirnseite
- 11: Ansteuerschaltung
- 12: Feldsonde
- 13: Auswerteelektronik
- 14: Signalkonditionierer
- 15: Signalverarbeitungseinheit
- 16: Substrat
- 17: Metallisierung
- 17a: Durchkontaktierung
- 18: Metallfläche
- 18a: Durchkontaktierung
- 19: passive Komponente
- 20: passive Komponente
- 21: aktive Komponente

- x: Stapelrichtung
- z: Längsrichtung
- d: Abstand

## Patentansprüche

1. Vorrichtung zur Erzeugung eines nicht-thermischen Atmosphärendruck-Plasmas,
aufweisend
einen piezoelektrischen Transformator (1) vom Rosen-Typ, eine Ansteuerschaltung (11), die dazu ausgelegt ist, ein Eingangssignal an den piezoelektrischen Transformator (1) anzulegen, und
eine Feldsonde (12), die dazu ausgestaltet ist, eine Feldstärke eines von dem piezoelektrischen Transformator (1) erzeugten elektrischen Feldes an einem Messpunkt zu messen,
wobei die Ansteuerschaltung (11) dazu ausgestaltet ist, unter Berücksichtigung der Messergebnisse der Feldsonde (12) das Eingangssignal anzupassen,
wobei die Ansteuerschaltung (11) ganz oder teilweise durch Software realisiert ist.

2. Vorrichtung gemäß dem vorherigen Anspruch,
wobei die Feldsonde (12) dazu ausgestaltet ist, eine Feldstärke eines von dem piezoelektrischen Transformator (1) erzeugten elektrischen Feldes an zumindest zwei Messpunkten zu messen.

3. Vorrichtung gemäß einem der vorherigen Ansprüche, wobei die Ansteuerschaltung (11) dazu ausgestaltet ist, unter Berücksichtigung der Messergebnisse der Feldsonde (12) eine Frequenz des Eingangssignals anzupassen.

4. Vorrichtung gemäß einem der vorherigen Ansprüche, wobei die Ansteuerschaltung (11) dazu ausgestaltet ist, unter Berücksichtigung der Messergebnisse der Feldsonde (12) eine Spannung des Eingangssignals, eine Stromstärke des Eingangssignals, eine Phase des Eingangssignals und/oder eine Signalform des Eingangssignals anzupassen.

5. Vorrichtung gemäß einem der vorherigen Ansprüche, wobei die Ansteuerschaltung (11) dazu ausgestaltet ist, unter Berücksichtigung der Messergebnisse der Feldsonde (12) das Eingangssignal derart anzupassen, dass die Frequenz des Eingangssignals der einer Serienresonanzfrequenz des piezoelektrische Transformators (1) entspricht oder dass die Frequenz des Eingangssignals der einer Parallelresonanzfrequenz des piezoelektrische Transformators (1) entspricht.

6. Vorrichtung gemäß einem der vorherigen Ansprüche, wobei die Ansteuerschaltung (11) dazu ausgestaltet ist, unter Berücksichtigung der Messergebnisse der Feldsonde (12) das Eingangssignal derart anzupassen, dass ein Maximum in der Feldstärke des von dem piezoelektrischen Transformator (1) erzeugten elektrischen Feldes sich an einer ausgangsseitigen Stirnseite (10) des piezoelektrischen Transformators (1) oder in einem vom piezoelektrischen Transformator (1) wegweisenden Halbraum vor der ausgangsseitigen Stirnseite (10) des piezoelektrischen Transformators (1) ausbildet.

7. Vorrichtung gemäß einem der vorherigen Ansprüche,
wobei die Feldsonde (12) ein Substrat (16) aufweisend ein isolierendes Material aufweist, und
wobei die Feldsonde (12) voneinander getrennte Metallisierungen (17) aufweist, die die zumindest zwei Messpunkte bilden.

8. Vorrichtung gemäß dem vorherigen Anspruch,
wobei die Feldsonde (12) eine Metallfläche (18) aufweist, und wobei die Vorrichtung dazu ausgestaltet ist, die Feldstärke an jedem Messpunkt durch eine Messung einer Spannung zwischen der Metallfläche (18) und dem jeweiligen Messpunkt zu bestimmen.

9. Vorrichtung gemäß Anspruch 7 oder 8,
wobei zumindest eine passive Komponente (19) in das Substrat (16) integriert ist,
und/oder
wobei zumindest eine passive Komponente (20) und/oder eine aktive Komponente (21) auf einer Oberfläche des Substrats (16) angeordnet sind.

10. Vorrichtung gemäß dem vorherigen Anspruch,
wobei die Ansteuerschaltung (11) vollständig oder teilweise durch eine oder mehrere passive Komponenten (19, 20), die in das Substrat (16) integriert sind oder auf der Oberfläche des Substrats (16) angeordnet sind, und/oder eine oder mehrere aktive Komponenten (21), die auf der Oberfläche des Substrats (16) angeordnet sind, ausgebildet ist.

11. Vorrichtung gemäß einem der vorherigen Ansprüche,
wobei die Feldsonde (12) zumindest drei voneinander getrennte Metallisierungen (17) aufweist, die je einen Messpunkt bilden, und
wobei die zumindest drei Metallisierungen (17) in einer Reihe angeordnet sind.

12. Vorrichtung gemäß dem vorherigen Anspruch,
wobei die Feldsonde (12) derart angeordnet ist, dass die Reihe parallel zu dem piezoelektrischen Transformator (1) angeordnet ist.

13. Vorrichtung gemäß einem der vorherigen Ansprüche, ferner aufweisend eine Auswerteelektronik (13) zur Weiterverarbeitung von von der Feldsonde (12) erfassten Messwerten,
wobei die Auswerteelektronik (13) mit der Ansteuerschaltung (11) verbunden ist.

14. Vorrichtung gemäß dem vorherigen Anspruch,
wobei die Ansteuerschaltung (11) dazu ausgestaltet ist, das an den piezoelektrischen Transformator (1) angelegte Eingangssignal an die Auswerteelektronik (13) zu übermitteln,
wobei die Auswerteelektronik (13) dazu ausgestaltet ist, aus den von der Feldsonde (12) erfassten Messwerten das vom piezoelektrischen Transformator (1) ermittelte Ausgangssignal zu ermitteln, und
wobei die Auswerteelektronik (13) dazu ausgestaltet ist, das Eingangssignal mit dem Ausgangssignal zu vergleichen.

15. Vorrichtung gemäß dem vorherigen Anspruch,
wobei bei dem Vergleich des Eingangssignals mit dem Ausgangssignal eine Spannung der Signale und/oder eine Stromstärke der Signale und/oder eine Impedanz und/oder eine Frequenz der Signale und/oder eine Phase der Signale betrachtet wird.

16. Vorrichtung gemäß einem der Ansprüche 14 oder 15, wobei bei dem Vergleich des Eingangssignals mit dem Ausgangssignal eine Parallelresonanzfrequenz und/oder eine Serienresonanzfrequenz des piezoelektrischen Transformators (1) ermittelt werden.

17. Vorrichtung gemäß einem der Ansprüche 13 bis 16, wobei die Auswerteelektronik (13) vollständig oder teilweise durch eine oder mehrere passive Komponenten (19, 20), die in das Substrat (16) integriert sind oder auf der Oberfläche des Substrats (16) angeordnet sind, und/oder eine oder mehrere aktive Komponenten (21), die auf der Oberfläche des Substrats (16) angeordnet sind, ausgebildet ist.

18. Vorrichtung gemäß einem der Ansprüche 13 bis 17,
wobei die Auswerteelektronik (13) dazu ausgestaltet ist, anhand einer Veränderung der Feldstärke eine vor der ausgangsseitigen Stirnseite (10) des piezoelektrischen Transformators (1) angeordnete Last zu erkennen, und
wobei die Ansteuerschaltung (11) derart ausgestaltet ist, dass nur dann eine zur Zündung eines nichtthermisches Atmosphärendruck-Plasmas ausreichende Leistung an den Eingangsbereich (2) des piezoelektrischen Transformators (1) angelegt wird, wenn vor der ausgangsseitigen Stirnseite (10) eine Last (18, 19, 22) erkannt ist.

19. Vorrichtung gemäß einem der Ansprüche 13 bis 18, wobei die Auswerteelektronik (13) ganz oder teilweise durch Software realisiert ist.

20. Vorrichtung gemäß einem der vorherigen Ansprüche, ferner aufweisend eine zweite Feldsonde (12), die dazu ausgestaltet ist, eine Feldstärke eines von dem piezoelektrischen Transformator (1) erzeugten elektrischen Feldes an zumindest zwei Messpunkten zu messen.

21. Vorrichtung gemäß einem der vorherigen Ansprüche, wobei der piezoelektrische Transformator (1) dazu ausgestaltet ist, an seiner ausgangsseitigen Stirnseite (10) ein Plasma zu zünden.

22. Vorrichtung gemäß einem der vorherigen Ansprüche, wobei die Feldsonde dazu ausgestaltet ist zumindest eines ausgewählt aus einem Druck, einer Temperatur, einer Feuchte, eine Leitfähigkeit, eine Ozonkonzentration, eine Gaszusammensetzung, eine Ionenkonzentration und/oder eine Partikelkonzentration zu messen.

23. Vorrichtung gemäß einem der vorherigen Ansprüche, wobei die Ansteuerschaltung dazu ausgestaltet ist, bei der Anpassung des Eingangssignals zumindest eines ausgewählt aus einem Druck, einer Temperatur, einer Feuchte, eine Leitfähigkeit, eine Ozonkonzentration, eine Gaszusammensetzung, eine Ionenkonzentration und/oder eine Partikelkonzentration zu berücksichtigen.

24. Vorrichtung gemäß einem der vorherigen Ansprüche, wobei die Ansteuerschaltung (11) dazu ausgestaltet ist, im laufenden Betrieb der Vorrichtung in festgelegten zeitlichen Abständen unter Berücksichtigung der Messergebnisse der Feldsonde (12) eine Korrektur des Eingangssignals vorzunehmen.

25. Vorrichtung gemäß einem der vorherigen Ansprüche, wobei die Anpassung des Eingangssignals kontinuierlich und/oder in Echtzeit erfolgt.

26. Vorrichtung gemäß einem der vorherigen Ansprüche, wobei die Vorrichtung zur Erzeugung von angeregten Molekülen, Ionen oder Radikalen dient, insbesondere zur Erzeugung von OH-Radikalen und/oder Stickoxid und/oder Ozon.

27. Verfahren zum Betrieb eines piezoelektrischen Transformators (1) vom Rosen-Typ, umfassend die Schritte:
- Anlegen eines Eingangssignals an den piezoelektrischen Transformator (1),
- Messen der Feldstärke eines von dem piezoelektrischen Transformator (1) erzeugten elektrischen Feldes durch eine Feldsonde (12) an einem Messpunkt,
- Anpassen des an den piezoelektrischen Transformator (1) angelegten Eingangssignals unter Berücksichtigung der Messwerte durch eine Ansteuerschaltung (11), wobei die Ansteuerschaltung (11) ganz oder teilweise durch Software realisiert ist,
wobei der piezoelektrische Transformator (1) zur Erzeugung eines nicht-thermischen Atmosphärendruck-Plasmas eingesetzt wird.

28. Verfahren gemäß dem vorherigen Anspruch,
wobei das Messen der Feldstärke eines von dem piezoelektrischen Transformator (1) erzeugten elektrischen Feldes durch die Feldsonde (12) an zumindest zwei Messpunkten erfolgt.

29. Verfahren gemäß Anspruch 27 oder 28,
wobei eine Frequenz des Eingangssignals schrittweise geändert wird und die Frequenz bestimmt wird, bei der sich ein Maximum in der Feldstärke an der ausgangsseitigen Stirnseite (10) des Transformators (1) oder in einem vom piezoelektrischen Transformator (1) wegweisenden Halbraum vor der ausgangsseitigen Stirnseite (10) des piezoelektrischen Transformators (1) einstellt, und
wobei die Frequenz des Eingangssignals anschließend auf die ermittelte Frequenz eingestellt wird.

30. Verfahren gemäß einem der Ansprüche 27 bis 29, ferner aufweisend die Schritte:
- Übermitteln des Eingangssignal an eine Auswerteelektronik (13),
- Ermitteln eines Ausgangssignal des piezoelektrischen Transformators (1) aus den von der Feldsonde (12) erfassten Messwerten durch die Auswerteelektronik (13), und
- Vergleichen des Eingangssignals mit dem Ausgangssignal durch die Auswerteelektronik (13).

31. Verfahren gemäß dem vorherigen Anspruch,
wobei bei dem Vergleich des Eingangssignals mit dem Ausgangssignal eine Parallelresonanzfrequenz des piezoelektrischen Transformators (1) ermittelt wird, und die Frequenz des Eingangssignals auf die Parallelresonanzfrequenz eingestellt wird.

32. Verfahren gemäß dem vorherigen Anspruch,
wobei das Plasma zur Erzeugung von angeregten Molekülen, Ionen oder Radikalen genutzt wird.

33. Verfahren gemäß einem der Ansprüche 27 bis 32, wobei durch einen Vergleich der von der Feldsonde (12) ermittelten Messwerte mit einem Referenzsignal eine Kalibration des piezoelektrischen Transformators (1) vorgenommen wird.

34. Verfahren gemäß einem der Ansprüche 27 bis 33, wobei durch einen Vergleich der von der Feldsonde (12) ermittelten Messwerte mit einem Referenzsignal eine Alterung und/oder eine Lebensdauer des piezoelektrischen Transformators (1) bestimmt wird.

## Claims

1. Device for producing a nonthermal atmospheric pressure plasma,
having
a piezoelectric transformer (1) of the Rosen type,
a driver circuit (11) which is designed to apply an input signal to the piezoelectric transformer (1), and
a field probe (12) which is configured to measure a field strength of an electric field produced by the piezoelectric transformer (1) at a measurement point, wherein the driver circuit (11) is configured to adapt the input signal while taking into account the measurement results of the field probe (12),
wherein the driver circuit (11) is embodied fully or partially by software.

2. Device according to the preceding claim,
wherein the field probe (12) is configured to measure a field strength of an electric field produced by the piezoelectric transformer (1) at at least two measurement points.

3. Device according to one of the preceding claims, wherein the driver circuit (11) is configured to adapt a frequency of the input signal while taking into account the measurement results of the field probe (12).

4. Device according to one of the preceding claims, wherein the driver circuit (11) is configured to adapt a voltage of the input signal, a current of the input signal, a phase of the input signal and/or a signal waveform of the input signal while taking into account the measurement results of the field probe (12).

5. Device according to one of the preceding claims, wherein the driver circuit (11) is configured to adapt the input signal while taking into account the measurement results of the field probe (12), in such a way that the frequency of the input signal corresponds to that of a series resonant frequency of the piezoelectric transformer (1) or in such a way that the frequency of the input signal corresponds to that of a parallel resonant frequency of the piezoelectric transformer (1).

6. Device according to one of the preceding claims, wherein the driver circuit (11) is configured to adapt the input signal while taking into account the measurement results of the field probe (12), in such a way that a maximum in the field strength of the electric field produced by the piezoelectric transformer (1) is formed at an output end side (10) of the piezoelectric transformer (1) or in a half-space, facing away from the piezoelectric transformer (1), in front of the output end side (10) of the piezoelectric transformer (1).

7. Device according to one of the preceding claims,
wherein the field probe (12) comprises a substrate (16) comprising an insulating material, and
wherein the field probe (12) comprises metallizations (17) that are separated from one another, which form the at least two measurement points.

8. Device according to the preceding claim,
wherein the field probe (12) comprises a metal face (18), and wherein the device is configured to determine the field strength at each measurement point by a measurement of a voltage between the metal face (18) and the respective measurement point.

9. Device according to Claim 7 or 8,
wherein at least one passive component (19) is integrated into the substrate (16),
and/or
wherein at least one passive component (20) and/or one active component (21) are arranged on a surface of the substrate (16).

10. Device according to the preceding claim,
wherein the driver circuit (11) is formed fully or partially by one or more passive components (19, 20) which are integrated into the substrate (16) or are arranged on the surface of the substrate (16), and/or by one or more active components (21) which are arranged on the surface of the substrate (16).

11. Device according to one of the preceding claims,
wherein the field probe (12) comprises at least three metallizations (17) that are separated from one another, each of which forms a measurement point, and
wherein the at least three metallizations (17) are arranged in a row.

12. Device according to the preceding claim,
wherein the field probe (12) is arranged in such a way that the row is arranged parallel to the piezoelectric transformer (1).

13. Device according to one of the preceding claims, furthermore comprising evaluation electronics (13) for further processing of measurement values recorded by the field probe (12),
wherein the evaluation electronics (13) are connected to the driver circuit (11).

14. Device according to the preceding claim,
wherein the driver circuit (11) is configured to transmit the input signal applied to the piezoelectric transformer (1) to the evaluation electronics (13),
wherein the evaluation electronics (13) are configured to determine the output signal determined by the piezoelectric transformer (1) from the measurement values recorded by the field probe (12), and
wherein the evaluation electronics (13) are configured to compare the input signal with the output signal.

15. Device according to the preceding claim,
wherein, during the comparison of the input signal with the output signal, a voltage of the signals and/or a current of the signals and/or an impedance and/or a frequency of the signals and/or a phase of the signals is considered.

16. Device according to one of Claims 14 and 15, wherein, during the comparison of the input signal with the output signal, a parallel resonant frequency and/or a series resonant frequency of the piezoelectric transformer (1) are determined.

17. Device according to one of Claims 13 to 16, wherein the evaluation electronics (13) are formed fully or partially by one or more passive components (19, 20) which are integrated into the substrate (16) or are arranged on the surface of the substrate (16), and/or by one or more active components (21) which are arranged on the surface of the substrate (16).

18. Device according to one of Claims 13 to 17,
wherein the evaluation electronics (13) are configured to detect a load arranged in front of the output end side (10) of the piezoelectric transformer (1) with the aid of a change in the field strength, and
wherein the driver circuit (11) is configured in such a way that a power sufficient for the ignition of a nonthermal atmospheric pressure plasma is applied to the input region (2) of the piezoelectric transformer (1) only when a load (18, 19, 22) is detected in front of the output end side (10).

19. Device according to one of Claims 13 to 18, wherein the evaluation electronics (13) are embodied fully or partially by software.

20. Device according to one of the preceding claims, furthermore comprising a second field probe (12), which is configured to measure a field strength of an electric field produced by the piezoelectric transformer (1) at at least two measurement points.

21. Device according to one of the preceding claims, wherein the piezoelectric transformer (1) is configured to ignite a plasma at its output end side (10).

22. Device according to one of the preceding claims, wherein the field probe is configured to measure at least one of the following: a pressure, a temperature, a humidity, a conductivity, an ozone concentration, a gas composition, an ion concentration and/or a particle concentration.

23. Device according to one of the preceding claims, wherein the driver circuit is configured to take into account at least one of the following during the adaptation of the input signal: a pressure, a temperature, a humidity, a conductivity, an ozone concentration, a gas composition, an ion concentration and/or a particle concentration.

24. Device according to one of the preceding claims, wherein the driver circuit (11) is configured to carry out a correction of the input signal at established time intervals during ongoing operation of the device while taking into account the measurement results of the field probe (12).

25. Device according to one of the preceding claims, wherein the adaptation of the input signal is carried out continuously and/or in real time.

26. Device according to one of the preceding claims, wherein the device is used to produce excited molecules, ions or radicals, in particular to produce OH radicals and/or nitrogen oxide and/or ozone.

27. Method for operating a piezoelectric transformer (1) of the Rosen type, comprising the following steps:
- application of an input signal to the piezoelectric transformer (1),
- measurement of the field strength of an electric field produced by the piezoelectric transformer (1) by a field probe (12) at a measurement point,
- adaptation of the input signal applied to the piezoelectric transformer (1) while taking into account the measurement values by way of a driver circuit (11), wherein the drive circuit (11) is embodied fully or partially by software,
wherein the piezoelectric transformer (1) is used to produce a nonthermal atmospheric pressure plasma.

28. Method according to the preceding claim,
wherein the measurement of the field strength of an electric field produced by the piezoelectric transformer (1) by the field probe (12) is carried out at at least two measurement points.

29. Method according to Claim 27 or 28,
wherein a frequency of the input signal is varied stepwise, and the frequency at which a maximum in the field strength is set up at the output end side (10) of the transformer (1) or in a half-space, facing away from the piezoelectric transformer (1), in front of the output end side (10) of the piezoelectric transformer (1), is determined, and
wherein the frequency of the input signal is subsequently adjusted to the frequency determined.

30. Method according to one of claims 27 to 29, furthermore comprising the steps:
- transmission of the input signal to evaluation electronics (13),
- determination of an output signal of the piezoelectric transformer (1) by the evaluation electronics (13) from the measurement values recorded by the field probe (12), and
- comparison of the input signal with the output signal by the evaluation electronics (13).

31. Method according to the preceding claim,
wherein, during the comparison of the input signal with the output signal, a parallel resonant frequency of the piezoelectric transformer (1) is determined, and
the frequency of the input signal is adjusted to the parallel resonant frequency.

32. Method according to the preceding claim,
wherein the plasma is used to produce excited molecules, ions or radicals.

33. Method according to one of Claims 27 to 32, wherein a calibration of the piezoelectric transformer (1) is carried out by a comparison of the measurement values determined by the field probe (12) with a reference signal.

34. Method according to one of Claims 27 to 33, wherein ageing and/or a lifetime of the piezoelectric transformer (1) is determined by a comparison of the measurement values determined by the field probe (12) with a reference signal.

## Revendications

1. Dispositif permettant de générer un plasma non thermique à pression atmosphérique, présentant
un transformateur piézoélectrique (1) de type Rosen,
un circuit d'excitation (11) qui est conçu pour appliquer un signal d'entrée au transformateur piézoélectrique (1), et
une sonde de champ (12) qui est configurée pour mesurer à un point de mesure une intensité de champ d'un champ électrique généré par le transformateur piézoélectrique (1),
dans lequel le circuit d'excitation (11) est configuré pour adapter le signal d'entrée en tenant compte des résultats de mesure de la sonde de champ (12),
dans lequel le circuit d'excitation (11) est réalisé entièrement ou partiellement sous forme de logiciel.

2. Dispositif selon la revendication précédente, dans lequel la sonde de champ (12) est configurée pour mesurer à au moins deux points de mesure une intensité de champ d'un champ électrique généré par le transformateur piézoélectrique (1).

3. Dispositif selon l'une quelconque des revendications précédentes, dans lequel le circuit d'excitation (11) est configuré pour adapter une fréquence du signal d'entrée en tenant compte des résultats de mesure de la sonde de champ (12).

4. Dispositif selon l'une quelconque des revendications précédentes, dans lequel le circuit d'excitation (11) est configuré pour adapter une tension du signal d'entrée, une intensité de courant du signal d'entrée, une phase du signal d'entrée et/ou une forme de signal du signal d'entrée en tenant compte des résultats de mesure de la sonde de champ (12).

5. Dispositif selon l'une quelconque des revendications précédentes, dans lequel le circuit d'excitation (11) est configuré pour adapter le signal d'entrée, en tenant compte des résultats de mesure de la sonde de champ (12), de telle sorte que la fréquence du signal d'entrée correspond à une fréquence de résonance série du transformateur piézoélectrique (1), ou que la fréquence du signal d'entrée correspond à une fréquence de résonance parallèle du transformateur piézoélectrique (1).

6. Dispositif selon l'une quelconque des revendications précédentes, dans lequel le circuit d'excitation (11) est configuré pour adapter le signal d'entrée, en tenant compte des résultats de mesure de la sonde de champ (12), de telle sorte qu'un maximum de l'intensité de champ du champ électrique généré par le transformateur piézoélectrique (1) se produit sur une face frontale (10) côté sortie du transformateur piézoélectrique (1) ou dans un espace semi-infini détourné du transformateur piézoélectrique (1) devant la face frontale (10) côté sortie du transformateur piézoélectrique (1).

7. Dispositif selon l'une quelconque des revendications précédentes, dans lequel la sonde de champ (12) présente un substrat (16) présentant un matériau isolant, et dans lequel la sonde de champ (12) présente des métallisations (17) séparées les unes des autres qui constituent lesdits au moins deux points de mesure.

8. Dispositif selon la revendication précédente, dans lequel la sonde de champ (12) présente une surface métallique (18), et dans lequel le dispositif est configuré pour déterminer l'intensité de champ à chaque point de mesure par une mesure d'une tension entre la surface métallique (18) et le point de mesure respectif.

9. Dispositif selon la revendication 7 ou 8,
dans lequel au moins un composant passif (19) est intégré dans le substrat (16), et/ou
dans lequel au moins un composant passif (20), et/ou un composant actif (21) sont disposés sur une surface du substrat (16).

10. Dispositif selon la revendication précédente, dans lequel le circuit d'excitation (11) est réalisé entièrement ou partiellement par un ou plusieurs composants passifs (19, 20) qui sont intégrés dans le substrat (16) ou sont disposés sur la surface du substrat (16), et/ou par un ou plusieurs composants actifs (21) qui sont disposés sur la surface du substrat (16).

11. Dispositif selon l'une quelconque des revendications précédentes,
dans lequel la sonde de champ (12) présente au moins trois métallisations (17) séparées les unes des autres qui constituent respectivement un point de mesure, et
dans lequel lesdites au moins trois métallisations (17) sont disposées sur une rangée.

12. Dispositif selon la revendication précédente, dans lequel la sonde de champ (12) est disposée de telle sorte que la rangée est disposée en parallèle au transformateur piézoélectrique (1).

13. Dispositif selon l'une quelconque des revendications précédentes, présentant en outre une électronique d'évaluation (13) pour le traitement ultérieur des valeurs de mesure détectées par la sonde de champ (12),
dans lequel l'électronique d'évaluation (13) est reliée au circuit d'excitation (11).

14. Dispositif selon la revendication précédente,
dans lequel le circuit d'excitation (11) est configuré pour transmettre à l'électronique d'évaluation (13) le signal d'entrée appliqué au transformateur piézoélectrique (1),
dans lequel l'électronique d'évaluation (13) est configurée pour établir à partir des valeurs de mesure détectées par la sonde de champ (12) le signal de sortie établi par le transformateur piézoélectrique (1), et
dans lequel l'électronique d'évaluation (13) est configurée pour comparer le signal d'entrée avec le signal de sortie.

15. Dispositif selon la revendication précédente, dans lequel une tension des signaux et/ou une intensité de courant des signaux et/ou une impédance et/ou une fréquence des signaux et/ou une phase des signaux sont prises en considération lors de la comparaison du signal d'entrée avec le signal de sortie.

16. Dispositif selon l'une quelconque des revendications 14 ou 15, dans lequel une fréquence de résonance parallèle et/ou une fréquence de résonance série du transformateur piézoélectrique (1) sont établies lors de la comparaison du signal d'entrée avec le signal de sortie.

17. Dispositif selon l'une quelconque des revendications 13 à 16, dans lequel l'électronique d'évaluation (13) est réalisée entièrement ou partiellement par un ou plusieurs composants passifs (19, 20) qui sont intégrés dans le substrat (16) ou sont disposés sur la surface du substrat (16), et/ou par un ou plusieurs composants actifs (21) qui sont disposés sur la surface du substrat (16).

18. Dispositif selon l'une quelconque des revendications 13 à 17,
dans lequel l'électronique d'évaluation (13) est configurée pour identifier à l'aide d'une variation de l'intensité de champ une charge disposée devant la face frontale (10) côté sortie du transformateur piézoélectrique (1), et
dans lequel le circuit d'excitation (11) est configuré de telle sorte qu'une puissance suffisante pour allumer un plasma non thermique à pression atmosphérique n'est appliquée à la zone d'entrée (2) du transformateur piézoélectrique (1) que si une charge (18, 19, 22) est identifiée devant la face frontale (10) côté sortie.

19. Dispositif selon l'une quelconque des revendications 13 à 18, dans lequel l'électronique d'évaluation (13) est réalisée entièrement ou partiellement sous forme de logiciel.

20. Dispositif selon l'une quelconque des revendications précédentes, présentant en outre une deuxième sonde de champ (12) qui est configurée pour mesurer à au moins deux points de mesure une intensité de champ d'un champ électrique généré par le transformateur piézoélectrique (1).

21. Dispositif selon l'une quelconque des revendications précédentes, dans lequel le transformateur piézoélectrique (1) est configuré pour allumer un plasma sur sa face frontale (10) côté sortie.

22. Dispositif selon l'une quelconque des revendications précédentes, dans lequel la sonde de champ est configurée pour mesurer au moins un élément sélectionné parmi une pression, une température, une humidité, une conductivité, une concentration en ozone, une composition d'un gaz, une concentration en ions et/ou une concentration en particules.

23. Dispositif selon l'une quelconque des revendications précédentes, dans lequel le circuit d'excitation est configuré pour prendre en considération lors de l'adaptation du signal d'entrée au moins un élément sélectionné parmi une pression, une température, une humidité, une conductivité, une concentration en ozone, une composition d'un gaz, une concentration en ions et/ou une concentration en particules.

24. Dispositif selon l'une quelconque des revendications précédentes, dans lequel le circuit d'excitation (11) est configuré pour effectuer une correction du signal d'entrée en cours de fonctionnement du dispositif à intervalles de temps fixes en tenant compte des résultats de mesure de la sonde de champ (12).

25. Dispositif selon l'une quelconque des revendications précédentes, dans lequel l'adaptation du signal d'entrée est effectuée en continu et/ou en temps réel.

26. Dispositif selon l'une quelconque des revendications précédentes, dans lequel le dispositif sert à générer des molécules, des ions ou des radicaux excités, en particulier pour générer des radicaux OH et/ou de l'oxyde d'azote et/ou de l'ozone.

27. Procédé permettant de faire fonctionner un transformateur piézoélectrique (1) de type Rosen, comprenant les étapes consistant à :
- appliquer un signal d'entrée au transformateur piézoélectrique (1),
- mesurer à un point de mesure l'intensité de champ d'un champ électrique généré par le transformateur piézoélectrique (1) par une sonde de champ (12),
- adapter le signal d'entrée appliqué au transformateur piézoélectrique (1) en tenant compte des valeurs de mesure par un circuit d'excitation (11), dans lequel le circuit d'excitation (11) est réalisé entièrement ou partiellement sous forme de logiciel,
dans lequel le transformateur piézoélectrique (1) est mis en œuvre pour générer un plasma non thermique à pression atmosphérique.

28. Procédé selon la revendication précédente, dans lequel la mesure de l'intensité de champ d'un champ électrique généré par le transformateur piézoélectrique (1) est effectuée par la sonde de champ (12) à au moins deux points de mesure.

29. Procédé selon la revendication 27 ou 28,
dans lequel une fréquence du signal d'entrée est modifiée progressivement, et la fréquence est déterminée à laquelle un maximum de l'intensité de champ se produit sur la face frontale (10) côté sortie du transformateur (1) ou dans un espace semi-infini détourné du transformateur piézoélectrique (1) devant la face frontale (10) côté sortie du transformateur piézoélectrique (1), et
dans lequel la fréquence du signal d'entrée est ensuite réglée sur la fréquence établie.

30. Procédé selon l'une quelconque des revendications 27 à 29, présentant en outre les étapes consistant à :
- transmettre le signal d'entrée à une électronique d'évaluation (13),
- établir par l'électronique d'évaluation (13) un signal de sortie du transformateur piézoélectrique (1) à partir des valeurs de mesure détectées par la sonde de champ (12), et
- comparer par l'électronique d'évaluation (13) le signal d'entrée avec le signal de sortie.

31. Procédé selon la revendication précédente, dans lequel une fréquence de résonance parallèle du transformateur piézoélectrique (1) est établie lors de la comparaison du signal d'entrée avec le signal de sortie, et la fréquence du signal d'entrée est réglée sur la fréquence de résonance parallèle.

32. Procédé selon la revendication précédente, dans lequel le plasma est utilisé pour générer des molécules, des ions ou des radicaux excités.

33. Procédé selon l'une quelconque des revendications 27 à 32, dans lequel un étalonnage du transformateur piézoélectrique (1) est effectué par une comparaison des valeurs de mesure, établies par la sonde de champ (12), avec un signal de référence.

34. Procédé selon l'une quelconque des revendications 27 à 33, dans lequel un vieillissement et/ou une durée de vie du transformateur piézoélectrique (1) sont déterminés par une comparaison des valeurs de mesure établies par la sonde de champ (12), avec un signal de référence.
